(19) Europäisches Patentamt
European Patent Office
Office européen des brevets

(11) **EP 4 148 781 A2**

(12) **EUROPEAN PATENT APPLICATION**

(43) Date of publication:
**15.03.2023 Bulletin 2023/11**

(21) Application number: **22207825.5**

(22) Date of filing: **16.11.2022**

(51) International Patent Classification (IPC):
***H01L 23/498*** (2006.01)

(52) Cooperative Patent Classification (CPC):
H01L 23/49822; **H01L 23/49838;** H01L 21/4857;
H01L 23/49816; H01L 23/49827

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **AT & S Austria Technologie &
Systemtechnik
Aktiengesellschaft
8700 Leoben-Hinterberg (AT)**

(72) Inventor: **Oggioni, Stefano Sergio
8700 Leoben (AT)**

(74) Representative: **Dilg, Haeusler, Schindelmann
Patentanwaltsgesellschaft mbH
Leonrodstraße 58
80636 München (DE)**

(54) **COMPONENT CARRIER WITH MUTUALLY OFFSET ROWS OF EQUIDISTANT WIRING ELEMENTS**

(57) A component carrier (100), which comprises a stack (102) comprising at least one electrically conductive layer structure (104) and at least one electrically insulating layer structure (106), wherein the at least one electrically conductive layer structure (104) comprises a plurality of wiring elements (108) arranged in a wiring plane (162) in the at least one electrically insulating layer structure (106) to form a first row (110) of equidistant wiring elements (108) arranged along a straight direction within the wiring plane (162), and a second row (112) of equidistant wiring elements (108) arranged along the straight direction within the wiring plane (162) and being offset along the straight direction with respect to the wiring elements (108) of the first row (110).

Fig. 1

EP 4 148 781 A2

Processed by Luminess, 75001 PARIS (FR)

Fig. 2

**Description**

The invention relates to a component carrier, and to a method of designing a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

Designing component carriers for achieving compliance with one or more target requirements, for instance defined by a specification, may be difficult, in particular when surface mounting at least one powerful electronic component on the component carrier .

It is an object of the invention to enable manufacture of component carriers for achieving compliance with one or more target requirements.

In order to achieve the object defined above, a component carrier, and a method of designing a component carrier according to the independent claims are provided.

According to an exemplary embodiment of the invention, a component carrier is provided which comprises a stack comprising at least one electrically conductive layer structure and at least one electrically insulating layer structure, wherein the at least one electrically conductive layer structure comprises a plurality of wiring elements arranged in a wiring plane in the at least one electrically insulating layer structure to form a first row of equidistant wiring elements arranged along a straight direction within the wiring plane, and a second row of equidistant wiring elements arranged along the straight direction within the wiring plane and being offset along the straight direction with respect to the wiring elements of the first row.

According to another exemplary embodiment of the invention, a method of designing a component carrier is provided which comprises a stack comprising at least one electrically conductive layer structure and at least one electrically insulating layer structure, wherein the method comprises designing the at least one electrically conductive layer structure to comprise a plurality of wiring elements arranged in a wiring plane in the at least one electrically insulating layer structure to form a first row of equidistant wiring elements arranged along a straight direction within the wiring plane, and a second row of equidistant wiring elements arranged along the straight direction in the wiring plane and being offset along the straight direction with respect to the wiring elements of the first row.

According to still another exemplary embodiment of the invention, a program element (for instance a software routine, in source code or in executable code) is provided, which, when being executed by a processor (such as a microprocessor or a CPU), is adapted to control or carry out a method having the above mentioned features.

According to yet another exemplary embodiment of the invention, a computer-readable medium (for instance a CD, a DVD, a USB stick, an SD card, a floppy disk or a hard disk, or any other (in particular also smaller) storage medium) is provided, in which a computer program is stored which, when being executed by a processor (such as a microprocessor or a CPU), is adapted to control or carry out a method having the above mentioned features.

Data processing which may be performed according to embodiments of the invention can be realized by a computer program, that is by software, or by using one or more special electronic optimization circuits, that is in hardware, or in hybrid form, that is by means of software components and hardware components.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, a ceramic substrate, a flexible substrate, and an IC (integrated circuit) substrate. A component carrier may also be a hybrid board combining different ones of the above mentioned types of component carriers.

In the context of the present application, the term "stack" may particularly denote a sequence of two or more layer structures formed on top of each other. For instance, layer structures of a layer stack may be connected by lamination, i.e. the application of heat and/or pressure. Preferably, the stacked layer structures may be arranged parallel to each other.

In the context of the present application, the term "layer structure" may particularly denote a continuous layer, a patterned layer, or a plurality of nonconsecutive islands within a common plane.

In the context of the present application, the term "wiring elements" may particularly denote electrically conductive elements forming part of a wiring or electric interconnection within a dielectric matrix of the stack. Wiring elements may be formed within an electrically insulating layer structure and as part of an electrically conductive layer structure. The wiring elements may comprise vertical through-connections for creating vertical electrical interconnections between different layer structures of the stack. The wiring elements may comprise electrically conductive through-connections extending through the thickness of the layer structure(s) and/or stack, preferably from one main surface to the opposed main surface of said layer structure(s) and/or stack, and/or along a perpendicular or inclined direction with respect to one of the main surfaces of said layer structure(s) and/or stack. Such connections may be vias, such as metallic laser vias, metallic mechanically drilled vias, sleeve shaped vias, full metal vias, metallic posts, or the like. Wiring elements may also comprise horizontal electrically conductive structures, such as traces and/or pads. Moreover, wiring elements may have straight and/or tapered shapes, e.g. cylindrical or frustoconical shapes. Moreover, wiring elements may be constructed in a way to be coaxially nested one into the other without electrical contact between the inner and the outer hosting structures.

In the context of the present application, the term "row of equidistant wiring elements" may denote a group of wiring elements arranged along a straight direction and having a constant mutual spacing between each pair of adjacent wiring elements of said row. In other words, the mutual spacing may be the same for each two neighboured wiring elements belonging to the group. For example, only the equidistant wiring elements of the row may be arranged along said straight direction. Alternatively, it is also possible that one or more further wiring elements are arranged between the equidistant wiring elements of the row along said straight direction. For example, a row of equidistant wiring elements may be a sequence of at least three, in particular of at least ten, wiring elements with the same mutual distance with respect to its neighbouring wiring element or elements of the group. A person skilled in the art will understand that, when forming equidistant wiring elements, technical tolerances (in particular manufacturing tolerances) may occur inevitably, which may lead to a very small deviation of an exactly identical distance between adjacent wiring elements of the row. However, when designing a component carrier for subsequent manufacture, equidistant wiring elements can be defined (for example in a design file) to have the same mutual target distance from each other. For example, actually manufactured equidistant wiring elements may have a mutual spacing or distance from each other which may deviate from an identical target distance by not more than a wiring element diameter. For example, actually manufactured equidistant wiring elements may have a mutual spacing or distance from each other which may deviate from an identical target distance by less than 5%, in particular by less than 2%. Due to technical tolerances, also dimensions (such as diameters) of equidistant wiring elements may show unavoidable variations, although - in an embodiment - equidistant wiring elements can be constructed (for example in a design file) to have the same dimensions (such as diameters). The length between two mutual wiring elements may be measured from the centre of a first wiring element to the centre of a second wiring element (in particular in nearest proximity along said straight direction).

In the context of the present application, the term "offset rows of wiring elements" may particularly denote rows of wiring elements being arranged with a spatial shift between, on the one hand, the equidistant wiring elements of the first row and, on the other hand, the equidistant wiring elements of the second row along a straight direction along which also the wiring elements of the first row and of the second row are arranged. More specifically, the equidistant wiring elements of the second row may be displaced as a whole along the straight direction with regard to the equidistant wiring elements of the first row. Due to said non-zero offset, the wiring elements of the first row may be out of alignment with respect to the wiring elements of the second row what concerns said straight direction. Apart from this, the wiring elements of the first row and the wiring elements of the second row may or may not be spaced or offset from each other along a further direction perpendicular to said straight direction. Preferably, the wiring elements of the first row and the wiring elements of the second row may be parallel shifted in space. Both said directions (i.e. the straight direction and the further direction) may be within a common wiring plane.

In the context of the present application, the term "wiring plane" may particularly denote a common (in particular horizontal) plane on that the rows (i.e the first and the second rows) of the wiring elements are provided. The common plane may be defined from a planar view perpendicular to one main surface of a layer structure and/or stack. The common plane may be defined as a plane parallel to a main surface of a layer structure and/or stack, preferably the common plane corresponds to a main surface of a layer structure and/or stack.

According to an exemplary embodiment of the invention, a component carrier and a corresponding design and manufacturing architecture may be provided in which wiring elements of a wiring plane are arranged in accordance with a well-defined geometrical pattern. In particular, different rows of equidistantly spaced wiring elements may be provided, wherein a mutual spatial offset is implemented between different rows of equidistant wiring elements. By such an approach, a relatively equally ordered distribution of the wiring elements within a respective wiring plane may be ensured, thereby improving or optimising the amount of the wiring elements within the available area. The distributed array of wiring elements arranged in accordance with mutually offset rows of equidistant wiring elements may form a highly appropriate basis of a simple model of arranging wiring elements in a regular pattern. The virtual model of regular equidistant wiring elements in mutually offset rows may allow to create a well-defined pattern of wiring structures which are capable of fulfilling even sophisticated electronic functions. Said simple and nevertheless highly symmetric model leaves sufficient degrees of freedom for adjusting design parameters (such as mutual distance, offset value, number and dimensions of wiring elements, etc.) for achieving compliance with target properties (for instance a desired current carrying capability) of the component carrier to be manufactured based on the modelled wiring plane or planes. For instance, the described arrangement of wiring elements may lead to a structure which is highly advantageous for realizing electronic tasks such as power supply, power distribution and/or the provision of one or more reference potentials (such as an electric ground potential) within a component carrier.

In the following, further exemplary embodiments of the component carrier and the method will be explained.

In an embodiment, at least part of the wiring elements are arranged at centers of hexagonal virtual cells of the wiring plane, each of said hexagonal virtual cells being adjacent one to the other sharing a respective side of a respective hexagon with a respective adjacent hexagon. Hence, a plane of wiring elements of a component carrier may be configured in accordance with Voronoi cells with hexagonal outline. A wiring plane or a region of interest thereof may thus be virtually divided into a plurality of hexagonal virtual cells which may be connected directly with each other along respective sides. For instance, the wiring elements may be arranged in centres of such hexagonal virtual cells, and/or at corners thereof. Such a regular pattern of virtual hexagonal virtual (or imaginary) cells may translate into a wiring pattern of high symmetry which may lead to a well-defined electric distribution system. Hence, no free space and no gaps may remain between the adjacent hexagonal virtual cells. As an alternative to hexagonal virtual cells, other embodiments may also implement cells with another outline, for instance regular triangular cells or rectangular (preferably square) cells. A row of equidistant wiring elements may comprise at least a portion of at least one outline of the hexagonal virtual cell.

In an embodiment, the hexagonal virtual cells are delimited by a regular hexagon. A regular hexagon may be a hexagon having six sides of identical length with 120° angles between each pair of adjacent sides. Such a highly symmetrical pattern may fill an entire two-dimensional surface portion of a wiring plane without gaps in between, i.e. continuously.

In an embodiment, another part of the wiring elements are arranged at corners of the hexagonal virtual cells. When arranging part of the wiring elements in centres and another part of the wiring elements at corners of a hexagonal virtual cell, different groups of wiring elements with different functions may be spatially separated from each other without a loss of a well-defined pattern of wiring elements. For instance, a first part of wiring elements may provide electric power connections, whereas another part of wiring elements may relate to ground connections.

In an embodiment, the part of the wiring elements arranged at the centers of the hexagonal virtual cells provide a first electric function, and the other part of the wiring elements arranged at corners of the hexagonal virtual cells provide a second electric function being different from the first electric function. Thus, all central wiring elements may be grouped and may have assigned a common electronic function, for instance providing electricity at a first voltage level. In contrast to this, wiring elements of corners may be assigned to another functional group and may provide another electronic function in the framework of the component carrier, for instance may handle electricity at a second electric voltage level different from the first electric voltage level. According to an alternative embodiment, all or at least some of the wiring elements arranged at the centers of the hexagonal virtual cells and all or at least some of the wiring elements arranged at the corners of the hexagonal virtual cells have the same electric function.

In an embodiment, a mutual distance between adjacent equidistant wiring elements of the first row equals to a mutual distance between adjacent equidistant wiring elements of the second row. In other words, a spacing of adjacent ones of the equidistant wiring elements of the first row may be the same as a mutual spacing between adjacent ones of the equidistant wiring elements of the second row. This may provide a high degree of symmetry.

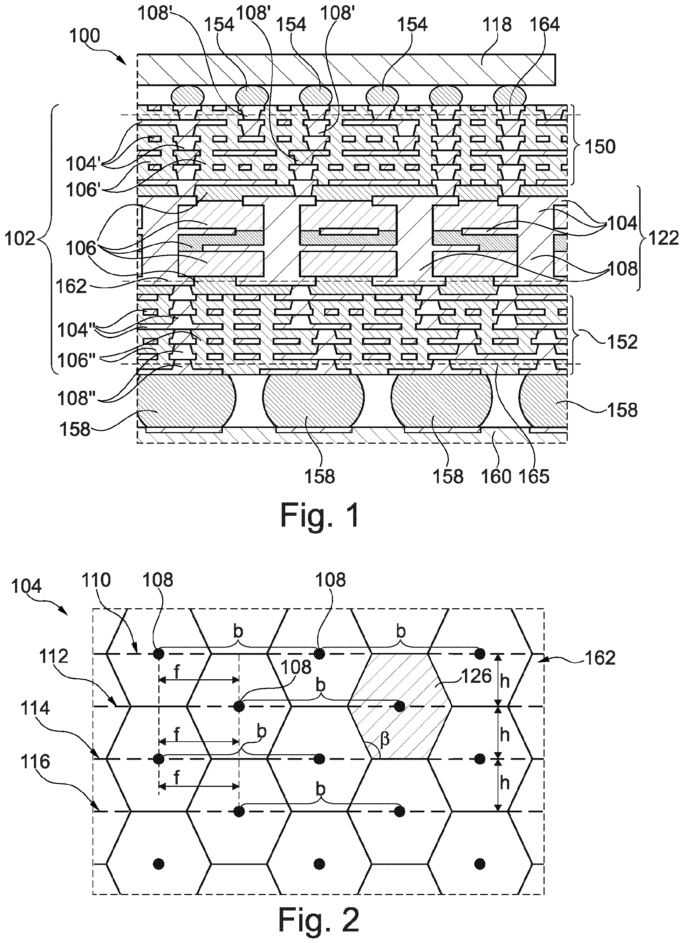

In an embodiment, an offset value of the offset of the equidistant wiring elements of the second row with respect to the equidistant wiring elements of the first row along the straight direction is 1/2 of a mutual spacing between adjacent equidistant wiring elements of the first row (see for example Figure 2). What concerns the straight direction, the described design rule may correspond to wiring elements of the second row being arranged in the middle between two respective wiring elements of the first row. In particular, such an embodiment may relate to a configuration in which the first row and the second row are also vertically displaced, i.e. are displaced also along a direction perpendicular to the straight direction. This may ensure a reliable electric separation between different wiring elements of different rows.

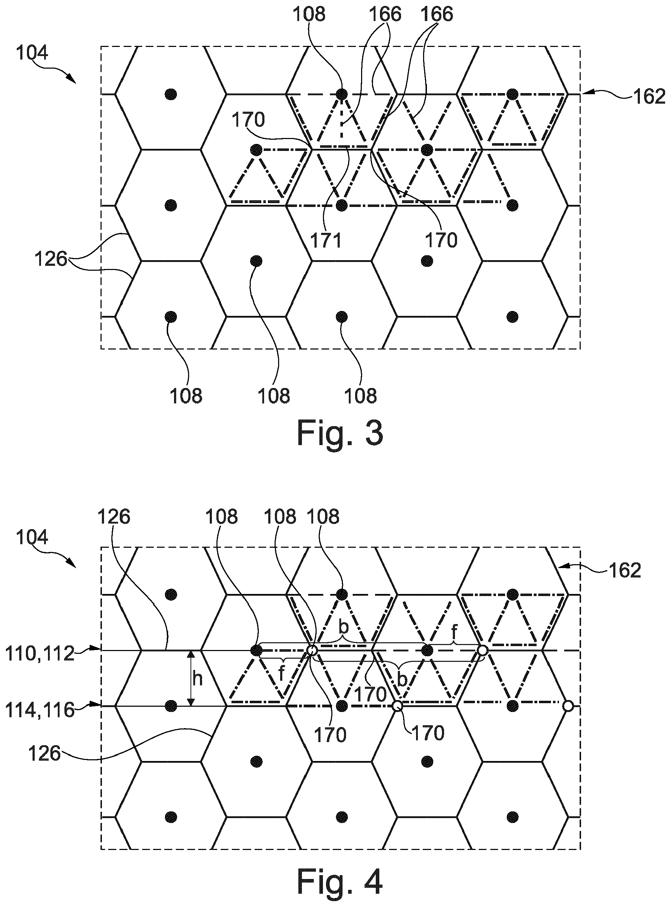

In another embodiment, an offset value of the offset of the equidistant wiring elements of the second row with respect to the equidistant wiring elements of the first row along the straight direction is 1/3 of a mutual spacing between adjacent equidistant wiring elements of the first row (see for example Figure 4). What concerns the straight direction, the described design rule may correspond to wiring elements of the second row being arranged closer to one than to another of two respective wiring elements of the first row, wherein a distance ratio may be 2:1. In particular, such an embodiment may relate to a configuration in which the first row and the second row are not vertically displaced, i.e. are all arranged along the straight direction without being spaced perpendicular thereto. Thus, this design rule may correspond to a configuration in which the equidistant wiring elements of the first row and of the second row are at the same level within the wiring plane. In other words, the first row and the second row may extend along the same straight direction without a mutual displacement perpendicular to said common straight direction. This design rule may allow to arrange a large number of wiring elements with small space consumption. Alternatively, this design rule may correspond to a configuration in which the equidistant wiring elements of the first row and of the second row are also vertically displaced, i.e. are displaced also along a direction perpendicular to the straight direction.

In an embodiment, a smallest distance of a wiring element of the second row from a wiring element of the first row is 1/3 of a mutual spacing between adjacent equidistant wiring elements of the first row (see also for example Figure 4). Such a configuration may relate to a spacing between wiring elements of different functional groups in relation to wiring elements of the same functional group. In such an embodiment, the second row may be aligned with the first row. Still referring to the previously described embodiment, the first and the second row may be provided without vertical displacement with respect to each other in the wiring plane, so that the offset may be along the straight direction. In an alternative embodiment, the equidistant wiring elements of the first row and of the second row are also vertically displaced, i.e. are displaced also along a direction perpendicular to the straight direction.

In an embodiment, the second row is spaced with respect to the first row along a further straight direction perpendicular to the straight direction (see for example Figure 2). For example, such a spacing may be in accordance with 1/6 of a mutual spacing between adjacent equidistant wiring elements of a row by $\sqrt{3}$ . Thus, the first row and the second row may be offset with respect to each other along the straight direction, and additionally a further offset perpendicular thereto but still in the wiring plane may be present as well, enhancing the possibilities of several different wiring elements (eventually with different electric functions or dimensions) in several available positions with respect to the adjacent wiring elements, assuring a reliable and/or an ordered distribution of all wiring elements within the available area of the wiring plane.

In an embodiment, the second row is aligned with the first row and a third row is spaced with respect to the first row and the second row along the perpendicular straight direction. Hence, at least a third row may be added to the first and the second row, wherein also the third row may have an ordered sequence of (preferably equidistant) wiring elements.

In an embodiment, a further electrically conductive layer structure of the stack comprises a plurality of further wiring elements which are arranged in a further wiring plane parallel to the wiring plane and which have a corresponding pattern as but another density of wiring elements than the electrically conductive layer structure with the first row and the second row of wiring elements. For instance, the arrangement of the wiring elements described above may relate to a core with metallized through holes (i.e. metal filled mechanically or laser drilled through-holes or plated mechanical or laser drilled through-holes), whereas the further wiring elements according to the presently described embodiment may relate to a build-up layer on top or bottom of such a core and may comprise metallized laser vias (or vice versa). For example, a wiring plane with wiring elements comprising metallized laser vias may have smaller dimensioned wiring elements and a higher number of wiring elements per area or volume than a core having larger metallized through-holes with a smaller number of wiring elements per area or volume. While the density of wiring elements may be different for said different wiring planes, the regularity of the pattern of wiring elements in such different wiring planes may be correspondingly. It is possible that the wiring elements and the further wiring elements are electrically coupled with each other, partially or entirely. For example, a plurality of further wiring elements (for instance metallized laser vias) may be electrically coupled with one wiring element (for example a metallized through hole) by connecting said further wiring elements to an annular land around said wiring element. In one example, the arrangement of at least one, in particular at least some of the further wiring elements may be aligned directly above and/or below in stack thickness direction with the wiring elements. Additionally or alternatively, the arrangement of at least one, in particular at least some of the further wiring elements may not be aligned directly above and/or below in stack thickness direction with the wiring elements.

In an embodiment, the wiring elements are arranged to form a third row next to the second row and having an arrangement of wiring elements as the first row, and a fourth row next to the third row and having an arrangement of wiring elements as the second row (see for example Figure 2). To put it shortly, the third row may have an ordering sequence as the first row, and the fourth row may have an ordering sequence as the second row. Thus, the symmetry of the first row and the second row may be continued by the third row and the fourth row, to thereby provide a two-dimensional pattern of wiring elements within the wiring plane with high degree of symmetry. The number of rows may be continued and extended as desired or required for a certain application. Furthermore, a symmetric pattern of wiring elements resulting from the repetition of the first, second, third and fourth rows arranged one next to the other may be provided. Preferably, the first, second, third and fourth row may be aligned parallel and the distance between each mutually nearest spaced row may be equal, respectively.

In an embodiment, the wiring elements are grouped into a plurality of wiring element groups of different electric functions. In particular, different groups of wiring elements may be assigned to different electric voltage levels. For example, wiring elements in centres of a respective virtual cell may be assigned to a first electric function such as the provision of a first voltage level, whereas wiring elements at corners of the virtual cells may be assigned to another electric function such as the provision of a (for instance higher or lower) electric voltage level. By taking this measure, electric power, electric signals and ground connections as well as different electric levels may be realized in a component carrier.

In an embodiment, the wiring elements are grouped into a plurality of wiring element groups of different dimensions. In particular, different groups of wiring elements with different dimensions may be assigned to different electric current carrying capabilities. A current carrying capability of a wiring element may be the capability of carrying a certain amount of electric current in a wiring plane in compliance with a predefined specification. Arranging the wiring elements according to a regular pattern, for instance in accordance with virtual Voronoi cells, may also allow to improve or even optimize the spatial distribution of the wiring elements so that minimum safety distances between wiring elements may be guaranteed depending on a respective value of the current carrying capability and/or a breakdown voltage requirement.

In an embodiment, the component carrier comprises a component being surface mounted on the stack. The above-mentioned wiring elements may be arranged, partially or entirely, in a shadow area of the surface mounted component. A shadow area of a surface mounted component may correspond to a spatial region in the stack in which electric connections for the component shall be arranged. For instance, the shadow area may taper from an interior of the stack towards the surface mounted component. Such a tapering may reflect the fact that a density of wiring elements can be higher closer to the surface mounted component compared to a stack portion further remote from the surface mounted component. Such a tapering may correspond to a redistribution function of the wiring elements.

A shadow area of the above-mentioned surface mounted component may be a projection of the surface mounted component onto wiring planes of the stack in which the wiring elements are arranged. In particular, the region directly below the component may be most critical in terms of an electric interconnection. For this purpose, specifically said shadow area beneath a surface mounted component (for instance having a very high number of I/O pads) may be advantageous. The shadow area may extend into the stack vertically, or in such a way that it tapers towards the surface mounted component. The latter measure may reflect a redistribution structure arrangement beneath the surface mounted component so as to achieve compliance with a larger pitch of a mounting base beneath the stack (for example a mounting base embodied as printed circuit board).

Hence, the component carrier may comprise at least one surface mounted component, such as a semiconductor chip, in particular a power semiconductor chip or a processor chip. It is also possible that a plurality of electronic components are surface mounted on the stack.

Additionally or alternatively, one or more electronic components may be embedded in the stack, and may also be served by the wiring elements concerning their electric interconnection.

In an embodiment, the wiring elements function for distributing electric power in the component carrier. This may be particularly advantageous for high performance computing applications, artificial intelligence applications, processor applications, and the like requiring a large amount of electric energy during operation.

In an embodiment, some of the wiring elements function for distributing signals in the component carrier. The arrangement of wiring elements in a wiring plane in rows with equidistant wiring elements may also support a reliable signal transport.

In an embodiment, some of the wiring elements function for providing a reference potential, in particular a ground potential in the component carrier. Also a ground potential or the like may be required for operating a surface mounted component.

In an embodiment, some of the wiring elements functioning for distributing electric power or signals or for providing a reference potential (such as a ground potential) are those provided on the first row or on the second row or on the third row. It is also possible that some other of the wiring elements with a different function are provided in another one of the first row or the second row or the third row. For example, each of the rows may have a separate function. Wiring elements of the first row may contribute to a first common function, whereas wiring elements of a second row may contribute to another electric function. If wiring elements of a third row are present, they may provide a third function, and so on. In an embodiment, the wiring elements may be used for a thermal task, in particular for controlling heat distribution inside of the component carrier.

In an embodiment, the at least one electrically conductive layer structure comprising the wiring elements is arranged in a core of the component carrier. Thus, a component carrier may have a stack with a central core of fully cured dielectric material having a high thickness and having metal filled mechanical drill holes extending therethrough. For example, a core may have a thickness in a range from 500 $\mu$m to 2 mm. A build-up may be formed on one or both of opposing main surfaces of such a core and may have a higher density of wiring elements, which may be embodied as metal filled laser vias. The core may have a key function in terms of distribution of power and signals and may therefore be designed in accordance with the equidistant wiring element rows, as described above.

In an embodiment, the wiring elements are arranged in accordance with Voronoi cells within the wiring plane. In mathematics, a Voronoi cell may denote a region or partition of a plane (presently a wiring plane) including all points of the plane closer to a specific object (in this case a metalized through hole) than to any other object in the plane. A set of Voronoi cells defines a Voronoi diagram. Voronoi cells may provide an excellent basis for determining an arrangement of wiring elements of a wiring plane of a stack. They have a high degree of symmetry and may be free of gaps in between. The high symmetry of a corresponding arrangement of wiring elements may translate into well-defined and highly appropriate electric properties.

In an embodiment, the Voronoi cells are hexagonal virtual cells, in particular each delimited by a regular hexagon. However, the Voronoi cells may also be triangular cells, rectangular cells, or other polygonal Voronoi cells.

In an embodiment, the method comprises arranging the wiring elements for adjusting a number of wiring elements in the wiring plane complying with a predefined specification. A specification may define attributes concerning the electric functionality of a wiring plane or of the component carrier to be designed as a whole. The wiring elements may then be arranged in the first row, the second row, and optionally in further rows so as to comply with the specification. Such a process may be carried out manually, or preferably automatically (for instance by executing a fitting routine and/or by applying artificial intelligence).

In an embodiment, the method comprises arranging the wiring elements for adjusting a current carrying capability of the wiring elements in the wiring plane and/or vertically across the stack. When designing the arrangement of the wiring elements, the achievement of a predefined current carrying capability per cross-sectional metal area of the wiring elements, for instance at least 10 A/mm$^2$, may be considered as a boundary condition which shall be fulfilled by the arrangement of the wiring elements.

In an embodiment, the method comprises determining at least one of a spatial distribution, a land diameter, a drill diameter and/or a functional grouping of the wiring elements complying with a predefined specification. Other parameters may be considered for the design of the wiring elements as well.

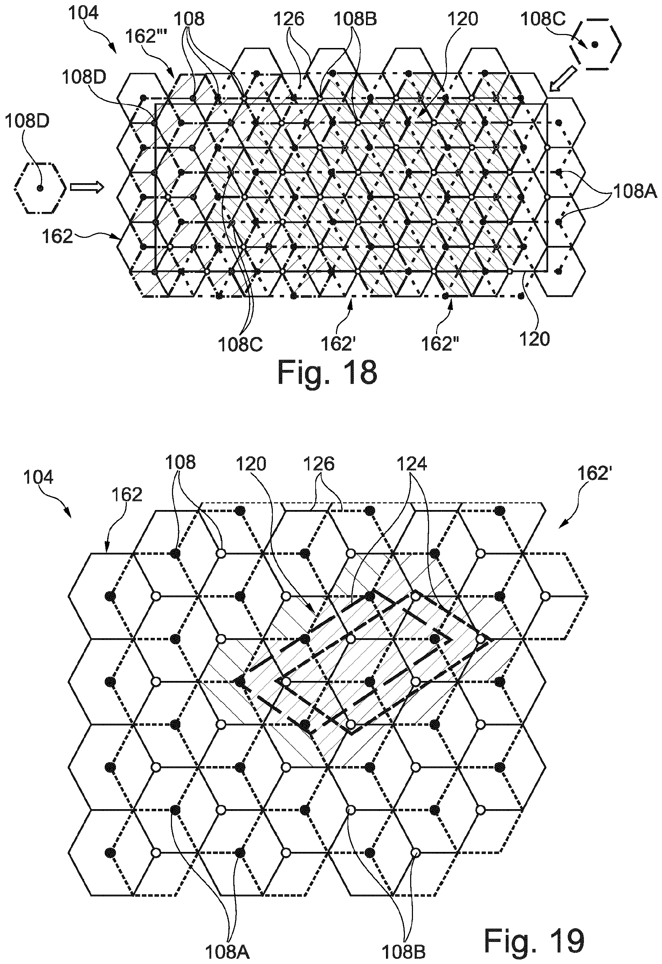

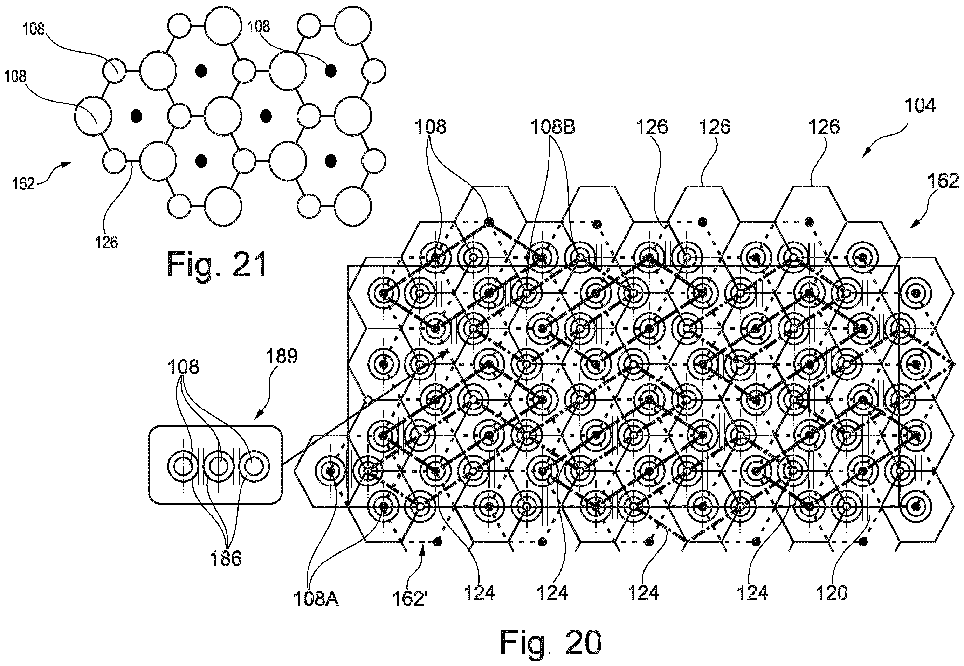

In an embodiment, the method comprises arranging the wiring elements in accordance with hexagonal Voronoi cells around respective wiring elements and by combining sets of wiring elements of neighbouring hexagonal Voronoi cells to four-sided blocks, in particular to parallelogram-type blocks (see for example Figure 19 or Figure 20). Voronoi cells may provide a virtual distribution of directly connected cells without gaps in between and may provide a proper basis for a symmetric arrangement of wiring elements. The definition of four-sided blocks, in particular parallelogram-type blocks, may further refine the designed arrangement of wiring elements.

In an embodiment, the component carrier comprises a stack which comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon or to host for example the mounting of a silicon or glass interposer. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins is called prepreg. These prepregs are often named after their properties for example FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide ($Al_2O_3$) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide ($Ga_2O_3$), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

In an embodiment, the component carrier related body is a laminate-type component carrier. In such an embodiment, the component carrier is a compound of multiple layer structures which are stacked and connected together by applying a pressing force and/or heat.

The aspects defined above and further aspects of the invention are apparent from the examples of embodiment to be described hereinafter and are explained with reference to these examples of embodiment.

Figure 1 illustrates a cross-sectional view of a component carrier according to an exemplary embodiment of the invention.

Figure 2 illustrates a plan view of a wiring plane of the component carrier according to Figure 1.

Figure 3 illustrates a plan view of a wiring plane of a component carrier according to an exemplary embodiment of the invention.

Figure 4 illustrates a plan view of a wiring plane of a component carrier according to an exemplary embodiment of the invention.

Figure 5 illustrates a plan view of different wiring planes of a component carrier according to an exemplary embodiment of the invention.

Figure 6 illustrates a plan view of a wiring plane of a component carrier according to an exemplary embodiment of the invention.

Figure 7 illustrates a plan view of different wiring planes of a component carrier according to an exemplary embodiment of the invention.

Figure 8 illustrates a plan view of a wiring plane of a component carrier according to an exemplary embodiment of the invention.

Figure 9 illustrates a cross-sectional view of a component carrier and a plan view of a wiring plane of the component carrier according to an exemplary embodiment of the invention.

Figure 10 illustrates a plan view of another wiring plane of the component carrier according to Figure 9.

Figure 11 illustrates a plan view of an overlay of the wiring planes of Figure 9 and Figure 10.

Figure 12 illustrates a plan view of wiring elements of a detail of a wiring plane of a component carrier according to an exemplary embodiment of the invention.

Figure 13 illustrates a plan view of a larger portion of the wiring plane of Figure 12.

Figure 14 illustrates a plan view of different wiring planes of a component carrier according to an exemplary embodiment of the invention.

Figure 15 illustrates a plan view of different wiring planes of a component carrier according to an exemplary embodiment of the invention.

Figure 16 illustrates a plan view of a wiring plane of a component carrier according to an exemplary embodiment of the invention to which an additional wiring element is added.

Figure 17 illustrates a plan view of different wiring planes of a component carrier according to an exemplary embodiment of the invention.

Figure 18 illustrates a plan view of different wiring planes of a component carrier according to an exemplary embodiment of the invention.

Figure 19 illustrates a plan view of different wiring planes of a component carrier according to an exemplary embodiment of the invention.

Figure 20 illustrates a plan view of different wiring planes of a component carrier according to an exemplary embodiment of the invention.

Figure 21 illustrates a plan view of a wiring plane of a component carrier according to an exemplary embodiment of the invention.

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

According to an exemplary embodiment of the invention, a component carrier (such as a printed circuit board or an integrated circuit substrate) may comprise a (preferably laminated) layer stack of electrically conductive and electrically insulating layer structures. A horizontal wiring plane of such a stack may comprise a well-defined regular pattern of metallic wiring elements, wherein at least some of these elements may be created to establish electrical interconnections between two or more layers of the stack. The wiring plane may constitute a first row of equidistant wiring elements arranged along a straight direction within the wiring plane and a second row of equidistant wiring elements arranged along the straight direction. A defined spatial offset, such as a mutual spatial displacement, may be foreseen between the first row and the second row according to which the group of wiring elements of the second row is shifted as a whole along the straight direction with regard to the group of wiring elements of the first row. In particular, the first row of equidistant connections or wiring elements may extend along a horizontal direction in the wiring plane. Correspondingly, a further second row of equidistant connections or wiring elements may extend along said horizontal direction in the wiring plane as well. The wiring elements of said further row may be offset with respect to the wiring elements of the first row along said horizontal direction. Consequently, a well-defined ordered or regular pattern of wiring elements may define a wiring plane and can be subjected to adjustment or even optimization by selecting values and/or attributes concerning remaining degrees of freedom (such as cross-sectional area of the respective wiring elements, a mutual spacing value between wiring elements of a respective row, an offset value between wiring elements of the different rows). By taking this measure, a numerically simple model may be used for virtually designing a component carrier for subsequent physical manufacture thereof. By adjusting a limited set of parameters (for instance by executing a fitting routine), one or more (in particular electric) target functions of the component carrier may be achieved, such as a target current carrying capability.

The described design of wiring elements may allow a proper arrangement of vertical connections of a component carrier, for instance to achieve compliance with a target current carrying capability. In particular, a wiring plane may be subdivided into a distributed plurality of Voronoi cells (such as hexagonal areas around each wiring element). An arrangement of cells forming part of a wiring plane without empty gaps in between may be symmetrical or asymmetrical (for instance, a center of some of the Voronoi cells may remain empty, i.e. without wiring element). For instance, dimensions, pitches, cell sizes and/or other degrees of freedom may then be adjusted for achieving compliance with a current carrying capability target, and/or with one or more other targets. In particular, a target of the design of wiring elements may be to define a power distribution in an interior of the stack, in particular in a core thereof.

When designing the arrangement of the wiring elements, it may be possible to also consider impedance and/or the power loop inductance as boundary condition.

Different regions of the stack may be provided with a different density of wiring elements, i.e. a different number of wiring elements per volume or area. For instance, such a density may be smaller in a core than in a build-up.

Preferably, said second row may be offset with respect to the first row along the horizontal direction with a measure of 1/2 or 1/3 of the distance of two adjacent wiring elements or connections of the same row.

It may also be possible that the distance between one wiring element or connection of a row and the closest wiring element or connection of the adjacent row corresponds to 1/3 of the distance between two adjacent wiring elements or connections of the same row.

In embodiments, different kinds of wiring elements or connections (for instance in terms of function, dimension, etc.) may be included in the model of the wiring plane. This may be done for a specific row or for multiple rows in the same wiring plane, or only for a portion thereof.

Beyond this, it may be possible that the wiring plane includes more than two rows of wiring elements. For example, a repeating sequence of the first and second rows may be provided for defining a two-dimensional array of wiring elements within the wiring plane.

With the above mentioned approach, it may be possible to design for example an HPC (high-performance computing) substrate core. Power feeding of a component carrier may be defined by the design of the wiring elements of the respective wiring plane.

Exemplary embodiments may also allow for a re-organization of wiring elements of a construction of a core of a component carrier to effectively meet one or more predefined power delivery targets (such as ampacity which equals to current carrying capacity, etc.).

Exemplary embodiments may also enable a defined or even optimized placement of laser vias in a build-up layer (for instance on a core) of a component carrier. In particular, this may allow to achieve an appropriate alignment to device power connections.

Exemplary embodiments may allow to reduce a number of metal-filled mechanical through holes for achieving compliance with one or more predefined targets or a specification. This may reduce manufacturing effort and processing time during drilling.

Furthermore, the described design rules for a component carrier may also achieve a consolidation in the design of multi-layer cores across multiple development projects. The described approach may also provide a simplification to modelling (in particular in terms of model uniformity, parametrization) and what concerns a prediction of functional boundaries.

In particular, the design of wiring elements in one or more wiring planes according to exemplary embodiments of the invention may involve different drill diameters (for example making use of larger and smaller drill bits, a lower number of the same drills per parts) which may allow to achieve a lower tear out or wearing per manufactured component carrier.

Advantageously, the described design model is scalable concerning technology developments. Such a technology development may be reflected by changed geometrical parameters, materials, processes, etc.

In particular, the described of component carrier can also be designed and manufactured with a multi-chip configuration on one and the same component carrier (for instance the same substrate).

Exemplary embodiments of the invention may provide a differential drilling power network distribution. More specifically, a methodology may be provided to achieve a high density power distribution in chip carriers (such as substrates), in particular for high performing computing and high computational units. In particular, this may allow to improve or even optimize power delivery within substrates used to host semiconductor devices.

Such an adjustment or even optimization may address the following three design areas: The first is the area where the higher level of power feeding is required, for example under computing units like CPUs, GPUs, AI accelerators, etc. The second is the area where I/O connections are placed to establish connectivity with other media, like a PCB. These may be placed along the periphery of the package enabling an easier fan-out wiring at board level. The third is a generic area where the transition of signals and return current paths are distributed to accomplish the transfer of electrical circuitry from the semiconductors' mounting side to the opposite side of the module's substrate to accomplish the interconnection with a hosting (for example mother-board) PCB.

In an exemplary embodiment, mechanical through holes (MTH) accomplishing top to bottom transitions can have different densities per unit of space.

**Figure 1** illustrates a cross-sectional view of a component carrier 100 according to an exemplary embodiment of the invention. **Figure 2** illustrates a plan view of a wiring plane 162 of the component carrier 100 according to Figure 1.

Component carrier 100 may be an integrated circuit (IC) substrate or a printed circuit board (PCB). The component carrier 100 may comprise a laminated layer stack 102 comprising, in a core 122 (which may be, for example, a multilayer core), one or more electrically conductive layer structures 104 and one or more electrically insulating layer structures 106. For example, the one or more electrically conductive layer structures 104 may comprise patterned metal layers (such as patterned copper foils or patterned deposited copper layers) and vertical through connections, for example copper filled vias, which may be created by drilling and plating. The one or more electrically insulating layer structures 106 may comprise a respective resin (such as a respective epoxy resin), preferably comprising reinforcing particles therein (for instance glass fibers or glass spheres). For example, the one or more electrically insulating layer structures 106 may be made of FR4. The one or more electrically insulating layer structures 106 may also comprise resin layers being free of glass (in particular glass fibers).

As shown, a plurality of through-holes are formed in central core 122 of stack 102, for example by mechanically drilling. The through-holes in the core 122 may be filled, partially or entirely, with electrically conductive material, such as copper, for example by plating. Inside of the central electrically insulating layer structure 106, a plurality of wiring elements 108, forming part of the central electrically conductive layer structure 104, are provided.

As shown in Figure 1 as well, an upper build-up 150 and a lower build-up 152 are formed on top and on the bottom of the core 122, respectively. The bottom sided build-up 152 can be constructed in a similar way as the top-sided build-up 150.

Upper build-up 150 comprises a plurality of further electrically conductive layer structures 104' and electrically insulating layer structures 106'. Inside of the further electrically insulating layer structures 106', a plurality of further wiring elements 108', forming part of the further electrically conductive layer structures 104', are provided.

Correspondingly, the lower build-up 152 comprises a plurality of further electrically conductive layer structures 104" and electrically insulating layer structures 106". Inside of the further electrically insulating layer structures 106", a plurality of further wiring elements 108", forming part of the further electrically conductive layer structures 104", are provided.

More specifically, a plurality of metal filled laser vias are provided in each of the build-ups 150, 152, forming said further wiring elements 108', 108". The further wiring elements 108', 108" have a higher density (i.e. a larger number of wiring elements per area or volume) and smaller dimensions than the metal filled mechanically drilled through-holes extending through the core 122 and forming the wiring elements 108.

On top of the upper build-up 150 and thus on an upper main surface of stack 102, a component 118 is surface mounted by an attachment technology such as soldering, thermocompression bonding, hybrid bonding, wire bonding, gluing or other metal to metal interdiffusion techniques. For example, component 118 is a semiconductor chip or a semiconductor package, for instance comprising at least one power semiconductor chip, a microprocessor, a central processing unit, a graphical processing unit, an artificial intelligence chip and/or another electronic component having a high electronic performance. The surface mounted component 118 is connected with the stack 102 by solder structures 154. It is also possible that a plurality of surface mounted components 118 are mounted on the stack 102.

At the bottom of the bottom-sided build-up 152, the stack 102 is mounted by further solder structures 158 on a mounting base 160, such as a printed circuit board (PCB), or mounted through the use of Land Grid Array pads into a socket, which is hosted for example by the PCB.

Electric power and electric signals may be guided through the core 122 and the build-ups 150, 152 and therefore between the mounting base 160 and the surface mounted component 118. Electricity transported through the stack 102 and therefore through the core 122 may include electric power and/or electric signals. Furthermore, it may be possible to provide at least one electric reference potential (for example a ground potential) at one or more wiring elements 108 extending through the core 122.

As can be taken from the above description, the electric interconnection and the supply of electricity of component carrier 100 can be very challenging, in particular when a high current carrying capability per area (of for instance at least 10 A/mm$^2$) and/or a high number of I/O connections of the surface mounted component 118 (for instance at least 10 or even at least 50 I/O connections) are required or desired. In order to meet these challenging demands concerning electric performance of the component carrier 100, wiring elements 108, 108', 108" in any of the electrically insulating layer structures 106, 106', 106" may be modelled and designed in a way as described below referring to Figure 2 and the subsequent figures. To put it shortly, a respective planar wiring layer may be defined, in particular wiring plane 162 extending through core 122. Additionally or alternatively, at least one other wiring plane may be designed, for instance a wiring plane 164 in upper build-up 150 and/or a corresponding wiring plane 165 in lower build-up 152.

In the following, it will be described on the example of wiring plane 162 as so how its wiring elements 108 can be designed according to an exemplary embodiment of the invention. This will be explained for wiring plane 162 of core 122, wherein the wiring plane 164 in upper build-up 150 and/or the wiring plane 165 in lower build-up 152 may be designed accordingly.

Now referring to Figure 2 showing a cross-section of Figure 1 through wiring plane 162, the corresponding electrically conductive layer structure 104 comprises a plurality of wiring elements 108. Said wiring elements 108 are arranged in wiring plane 162 and embedded in a dielectric matrix provided by the corresponding electrically insulating layer structure 106.

As shown in Figure 2, a first group of wiring elements 108 are arranged along a first row 110 of equidistant wiring elements 108 arranged along a straight direction (a horizontal direction according to Figure 2) within the wiring plane 162. More specifically, adjacent equidistant wiring elements 108 of the first row 110 all have same mutual distance, b, from each other. As shown as well in Figure 2, a second group of wiring elements 108 are arranged along a second row 112 of equidistant wiring elements 108 which are arranged along the same straight direction (the mentioned horizontal direction according to Figure 2) within the wiring plane 162 as the wiring elements 108 of the first row 110. More specifically, adjacent equidistant wiring elements 108 of the second row 110 all have to same mutual distance, b, from each other. Hence, the distance or spacing, b, may be the same for the first row 110 and for the second row 112. Thus, a mutual distance, b, between adjacent equidistant wiring elements 108 of the first row 110 equals to a mutual distance, b, between adjacent equidistant wiring elements 108 of the second row 112.

However, the second row 112 of equidistant wiring elements 108 is offset along the straight direction with respect to the wiring elements 108 of the first row 110 by an offset value, f. Descriptively speaking, if the wiring elements 108 of the second row 112 would be shifted along the horizontal straight direction by the offset value, f, said wiring elements 108 would be in alignment with the sequence of the wiring elements 108 of the first row 110. Furthermore, the offset value, f, of the equidistant wiring elements 108 of the second row 112 with respect to the equidistant wiring elements 108 of the first row 110 along the straight direction is 1/2 of a mutual spacing, b, between adjacent equidistant wiring elements 108 of the first row 110 or of the second row 112.

Furthermore, the second row 112 is spaced with respect to the first row 110 along a further straight direction perpendicular to the horizontal straight direction by a measure, h. In Figure 2, said further straight direction extends vertically. Furthermore, the second row 112 is aligned in parallel with the first row 110 according to Figure 2.

In addition to the wiring elements 108 of the first row 110 and of the second row 112, the wiring plane 162 of Figure 2 comprises a third row 114 next to the second row 112 and having an arrangement of wiring elements 108 as the first row 110. Furthermore, a fourth row 116 is arranged next to the third row 114 and has an arrangement of wiring elements 108 as the second row 112. Thus, a highly symmetric arrangement of wiring elements 108 is provided in the wiring plane 162.

Although only some wiring elements 108 are shown in the first row 110, in the second row 112, in the third row 114, and in the fourth row 116 in Figure 2, the described sequence of wiring elements 108 may be continued in accordance with the mentioned ordering scheme. Furthermore, also additional rows may be provided (not shown).

Again referring to Figure 2, all wiring elements 108 are arranged at centers of hexagonal virtual cells 126 into which the wiring plane 162 may be virtually divided. As shown, each of said hexagonal virtual cells 126 are adjacent one to the other without gaps in between. Thus, adjacent hexagonal virtual cells 126 share a respective side. Descriptively speaking, the entire wiring plane 162 may be subdivided into the hexagonal virtual cells 126 which are arranged side by side without gaps in between. Each of said hexagonal virtual cells 126 is delimited by a regular hexagon having six angles, $\beta$ , with 120° each. The hexagonal virtual cells 126 form a Voronoi pattern.

For example, the wiring elements 108 of the wiring plane 162 may function for distributing electric power in the component carrier 100, more specifically in the core 122 thereof. Such electric power may be used for operating surface mounted component 118. For example, some of the wiring elements 108 may function for distributing electric signals in the component carrier 100. For instance, said signals may be signals for driving the surface mounted component 118 and/or signals provided by surface mounted component 118. Yet other of the wiring elements 108 may function for providing a reference potential, in particular a ground potential, in the component carrier. For properly operating a surface mounted electronic component 118, it may also be necessary to provide a ground potential. In an embodiment, wiring elements 108 functioning for distributing electric power or signals or a ground potential may be those provided on the first row 110 or on the second row 112 or on the third row 114 or the fourth row 116. Other of the wiring elements 108 with a different function may be provided in another one of the first row 110 or the second row 112 or the third row 114 or the fourth row 116.

When designing component carrier 100, the wiring elements 108 may be arranged so as to comply with a predefined specification, for example in terms of current carrying capability or ampacity. In this context, the above-mentioned parameters (such as b, f, h) and/or other parameters and/or attributes (for instance the design of virtual cells 126) may be selected appropriately for achieving compliance with the specification on the requirements of at least one target attribute, function or property of the component carrier 100. For example, this can be done by a computer fit or manually.

To put it shortly, Figure 2 shows a plan view of wiring plane 162 illustrated in Figure 1. Each wiring plane 162, 164, 165, ..., can be subdivided into a plurality of Voronoi cells which are here embodied as hexagonal virtual cells 126. As shown, the regular hexagonal virtual cells 126 have six sides with a mutual 120° angle in between and being directly in contact with adjacent cells. By this virtual division of the respective wiring plane 162, 164, 165 in virtual cells 126, the entire area or part thereof may be covered. Wiring elements 108, 108', 108" of the electrically conductive layer structures 104, 104', 104" of the respective wiring plane 162, 164, 165 may be arranged all in centres of the regular hexagonal virtual cells 126. By taking this measure, a regular pattern is obtained which allows to maintain minimum distances between adjacent wiring elements 108, 108', 108", which may be required for electric safety purposes according to a specification to be met. By the arrangement in the various rows 110, 112, 114, 116, and by the mutual offset, f, between adjacent rows 110, 112, 114, 116, a highly symmetric pattern may be achieved which may meet simultaneously electric demands of a certain application. For optimizing a design, it may be possible to fit the position of the wiring elements 108, 108', 108" and/or the dimension and positions of the virtual cells 126 to achieve appropriate, or even the best, results. For instance, fitting parameters may be a length of a side of the regular hexagonal virtual cells 126, an area of the wiring elements 108, 108', 108" in the respective wiring plane 162, 164, 154, the offset value, f, etc.

Although not shown in Figure 1, a surface finish may be provided, such as a gold layer and/or a layer of solder resist.

Furthermore, it is possible - also in the embodiment of Figure 1 - that one or more components are embedded in the stack 102, in particular in the core 122. Therefore, the patterned wiring 108, 108', 108" may comprise at least one empty location or vacancy. Even if the embedding is strategically planned to avoid disruption of the power distribution network of wiring elements 108, 108', 108", the embedded component can be part of the power distribution network itself. Hence, there may be a possibility of having an empty location, in particular in the straight disposition of the vertical structures. **Figure 3** illustrates a plan view of wiring plane 162 of the component carrier 100 according to an exemplary embodiment of the invention. Figure 3 shows further auxiliary lines 166 extending from a respective wiring element 108 to a corner 170 or a side 171 of the hexagonal virtual cells 126. Also such parameters may be design parameters for designing a component carrier 100 in compliance with predefined target electric properties.

**Figure 4** illustrates a plan view of a wiring plane 162 of a component carrier 100 according to another exemplary embodiment of the invention.

In addition to wiring elements 108 located in centers of the respective hexagonal virtual cells 126, Figure 4 shows an embodiment in which in addition another part of the wiring elements 108 are arranged at corners 170 of the hexagonal virtual cells 126. For example, the part of the wiring elements 108 arranged at the centers of the hexagonal virtual cells 126 may provide a first electric function (for example a power supply function), and the other part of the wiring elements 108 arranged at the corners 170 of the hexagonal virtual cells 126 may provide a second electric function (for example a signal transmission function) being different from the first electric function.

In Figure 4, the first row 110 of equidistant wiring elements 108 and the second row 112 of equidistant wiring elements 108 both extend along the same horizontal straight direction, but are also in alignment what concerns a further straight direction perpendicular to said horizontal straight direction. In the example of Figure 4, rows 110, 112 are defined by a sequence of wiring elements 108 from first row 110, then from second row 112, then from first row 110, then from second row 112, and so on. For mapping the wiring elements 108 of the second row 112 onto the wiring elements 108 of the first row 110, it is thus sufficient to shift the wiring elements 108 of the second row 112 with respect to the wiring elements 108 of the first row 110 by the offset value, f, along said horizontal straight direction towards the left-hand side of Figure 4. In the illustrated embodiment, the wiring elements 108 in the centers of the hexagonal virtual cells 126 may form the first row 110 while the wiring elements 108 in the corners 170 of the hexagonal virtual cells 126 may form the second row 112. Here, the offset value, f, of the equidistant wiring elements 108 of the second row 112 with respect to the equidistant wiring elements 108 of the first row 110 along the straight direction is 1/3 of a mutual spacing, b, between adjacent equidistant wiring elements 108 of the first row 110 or of the second row 112.

As shown, a smallest distance (which equals to the offset value, f, in the shown embodiment) of a wiring element 108 of the second row 112 from a wiring element 108 of the first row 110 is 1/3 of a mutual spacing, b, between adjacent equidistant wiring elements 108 of the first row 110 or of the second row 112.

In Figure 4, the second row 112 is aligned with the first row 110. A third row 114 and a fourth row 116 are also aligned which each other but are spaced with respect to the first row 110 and the second row 112 along the perpendicular straight direction by the offset value, h.

It is also possible that the wiring elements 108 of the wiring plane 162 of Figure 4 are grouped into a plurality of wiring element groups (which may correspond to the various rows 110, 112, 114, 116) of different electric functions, for instance are assigned to different electric voltage levels and/or to different electric current carrying capabilities.

As already mentioned, the wiring elements 108 of Figure 4 are not only arranged in centres of the hexagonal virtual cells 126, but also at corners 170 thereof. For instance, the wiring elements 108 in the centres may have a first electric function, whereas the wiring elements 108 on the corners 170 may have another second electric function. For example, the wiring elements 108 in the centres and in the corners 170 may relate to different electric potentials. It is also possible that the wiring elements 108 in the centres provide electric power, whereas the wiring elements 108 in the corners 170 provide reference potentials or signals (or vice versa).

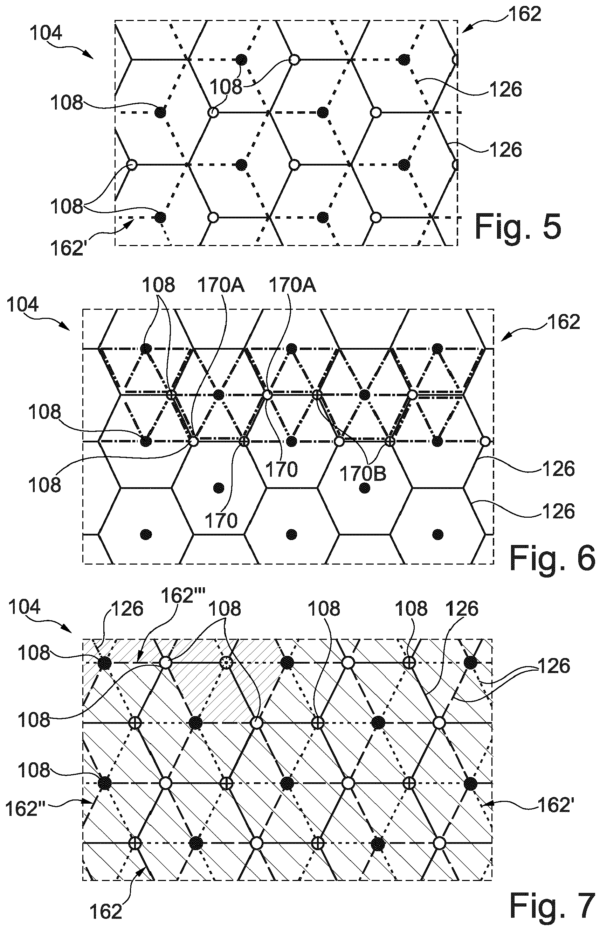

**Figure 5** illustrates a plan view of different wiring planes 162, 162' of a component carrier 100 according to an exemplary embodiment of the invention.

Figure 5 shows an arrangement of a first group of wiring elements 108 in centres of hexagonal virtual cells 126 of a first wiring plane 162 and a second group of wiring elements 108 in centres of further hexagonal virtual cells 126 of a second wiring plane 162'. Wiring planes 162, 162' may relate to different vertical levels of the stack 102 of the component carrier 100. In Figure 5, the hexagonal virtual cells 126 of the wiring planes 162, 162' are not only displaced perpendicular to the paper plane of Figure 5, but also within the paper plane of Figure 5 in horizontal and vertical directions. The wiring elements 108 of the different wiring planes 162, 162' may be interconnected with each other for accomplishing an electric connection in a vertical direction of stack 102.

**Figure 6** illustrates a plan view of a wiring plane 162 of a component carrier 100 according to an exemplary embodiment of the invention. In Figure 6, the wiring elements 108 provided in the corners 170 of the hexagonal virtual cells 126 and being provided in addition to the wiring elements 108 located in the centres, are subdivided into two different subgroups 170A, 170B. Corner-type wiring elements 108 of first group 170A may provide another electric function than corner-type wiring elements 108 of second group 170B. For instance, the electric functions provided by the groups 170A, 170B of corner-type wiring elements 108 may be the provision of an electric connection related to different electric voltage levels. By sub-grouping corner type wiring elements 108, the diversity of the provided electric functions may be further refined. In this example, first group 170A and second group 170B are alternating, in other words, they are not located directly next to each other at each corner 170 of the hexagonal virtual cells 126. In a different example, first group 170A and second group 170B are located directly next to each other at each corner 170 of the hexagonal virtual cells 126.

**Figure 7** illustrates a plan view of different wiring planes 162, 162', 162", 162''' of a component carrier 100 according to an exemplary embodiment of the invention. In this embodiment, wiring elements 108 are arranged in centers of hexagonal virtual cells 126 of four different wiring planes 162, 162', 162", 162''' at four different vertical levels of stack 102. Wiring elements 108 at different vertical levels may be interconnected with each other.

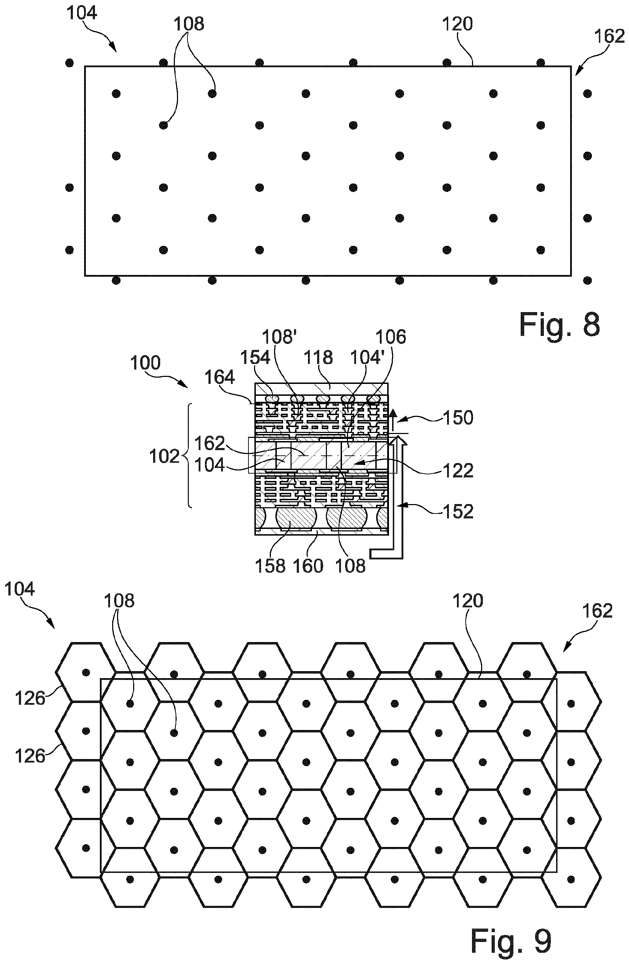

**Figure 8** illustrates a plan view of a wiring plane 162 of a component carrier 100 according to an exemplary embodiment of the invention.

In the embodiment of Figure 8, a shadow region 120 of a surface mounted component 118 is plotted. In such a shadow region 120, such as a projection of the outline of the surface mounted electronic component 118 into the stack 102, an appropriate wiring distribution may be of particular relevance, since such a surface mounted component 118 may have a high number of I/O pads with an electric functionality which has to be guided vertically through the stack 102. Hence, when a component 118 is surface mounted on the stack 102, wiring elements 108 with the above-mentioned pattern may be arranged in shadow area 120 of the surface mounted component 118. Although not shown in Figure 8, the shadow area 120 may taper from an interior of the stack 102 towards the surface mounted component 118.

Within the mentioned shadow area 120, a power voltage and an electric ground potential may be provided. Hence, it may be possible to approach a power feeding from an optimized geometrical computation of the distribution and the configuration of the wiring elements 108.

The distribution of the power features required by predefined values of the transfer of current may be done analytically. Then, the area of interest in terms of power feeding may be used to place the structures following the concept of tessellation, for instance creating areas of competence for each power structure. The concept of applying the creation of Voronoi cells with the positioning of the power feeding mechanically drilled through holes as a seed of each Voronoi cells is shown in Figure 9:

**Figure 9** illustrates a cross-sectional view of a component carrier 100 and a plan view of a wiring plane 162 of the component carrier 100 according to an exemplary embodiment of the invention.

The selection of the honeycomb structure of Figure 9 for defining hexagonal virtual cells 126 may be made to identify an equalized structure for the intermediate layers in the core construction to achieve a uniform contribution of power delivery to a determined closer point to the point of loads represented by the power connection of the surface mounted component 118. The core construction may have at least one additional layer (for example made with a prepreg) that may be used for a finer distribution of starting vertical structures of (for example stacked) laser vias.

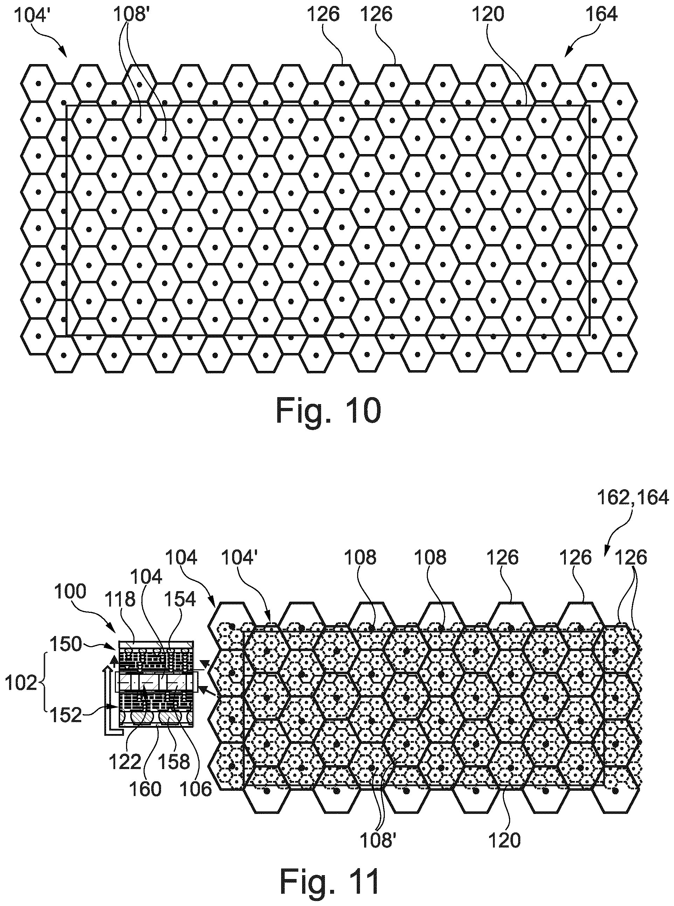

**Figure 10** illustrates a plan view of another wiring plane 164 of the component carrier 100 according to Figure 9. The other wiring plane 164 corresponds to upper build-up 150 and has a higher integration density than core 122. More specifically, a number of wiring elements 108' per area or volume may be higher in the upper build-up 150 than in the core 122. This may lead to a smaller dimension of the hexagonal virtual cells 126 in the upper build-up 150 than in the core 122.

As can be taken from Figure 9 and Figure 10, the honeycomb tessellation is scalable based on the available minimum geometries of the power feeding structures. While it is constructed into a section of the core 122 according to Figure 9, it can be applied as well (even partially) in the above layers in the build-up 150 according to Figure 10 with much smaller (scaled) dimensions. Based on a targeted technical specification, and for example considering the functional characteristics of each element of the power network, a computing algorithm can be constructed to define the necessary numerical quantity of elements necessary to reach the design objective. A further algorithm can be constructed to perform the tessellation (size and shape) of the assigned space, with the calculated quantities of elements. In particular, a corresponding computer program may be configured to render the size of the hexagons to optimize features. This may contribute to a miniaturization of the designed component carrier 100 or part thereof.

**Figure 11** illustrates a plan view of an overlay of the wiring planes 162, 164 of Figure 9 and Figure 10.

The dimensioning operation to size the Voronoi cells may be driven by the functional requirement of the specific structures of a component carrier to be designed. In case of mechanically drilled through holes there may be limitations imposed by construction factors of the core, for example the overall total aspect ratio between drill diameter and depth of the holes (thickness of the drilled core). The technology implementation may be governed by the physical limitation of the required steps to achieve the desired result. In the case of the mechanically drilled through holes, it can be the overall resulting aspect ratio limiting the capability of plating the interior part of the vertical holes creating a conductive deposition of copper on the wall of the hole. These limitations may be summarized in design rules to be used in the design of the structures. Examples are the minimum distance between holes (land to land) or the minimum drill diameter compatible with the overall thickness of the core. These geometries may determine other geometrical dimensions that are for example the maximum density (pitch) of the structures. The maximum possible density may determine the maximum contribution of these structures based on the individual capability of a single structure.

Referring again to Figure 10, further electrically conductive layer structure 104' of the stack 102 comprises a plurality of further wiring elements 108' which are arranged in further plane 164 parallel to the wiring plane 162 and which have a corresponding pattern as but another density of wiring elements than the electrically conductive layer structure 104 with the first row 110 and the second row 112 of wiring elements 108, as shown in Figure 9. Wiring plane 162 corresponds to a cross-section through core 122, whereas wiring plane 164 corresponds to a cross-section through the upper build-up 150. Figure 9 and Figure 10 illustrate a tessellation of the die shadow area 120. It may be possible to create areas of influence for each power domain. Figure 9 and Figure 10 illustrate that different wiring planes 162, 164 may be subdivided into hexagonal virtual cells 126 (or Voronoi cells with other geometry) with different cell dimensions. The dimensions of the hexagonal virtual cells 126 in the different wiring planes 162, 164 may reflect different integration densities (for example different numbers of wiring elements 108 per area or volume) in different wiring planes 162, 164. In the shown embodiment, wiring plane 162 has a smaller integration density than wiring plane 164. This may be a result of a redistribution layer or structure in an interior of the stack 102.

Thus, Figure 9 and Figure 10 shown that the described tessellation is scalable. Hence, the described technique may be adapted to specific power delivery targets and the available space.

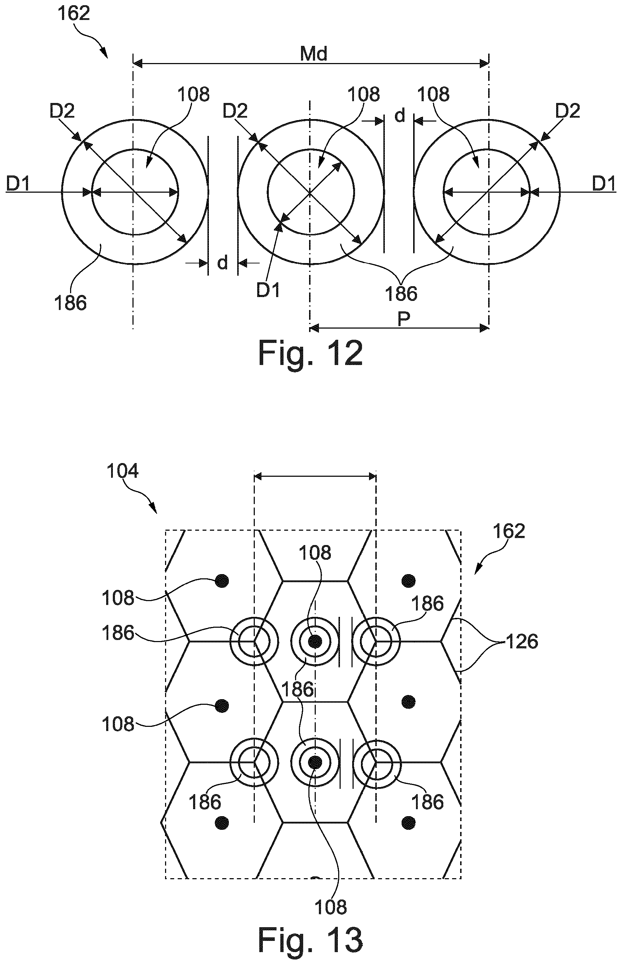

Still referring to Figure 9 and Figure 10, two different wiring planes 162 (Figure 9) and 164 (Figure 10) are illustrated. Wiring plane 162 of Figure 9 relates to core 122 with a relatively low number of wiring elements 108 per area. In contrast to this, Figure 10 corresponds to a layer of a respective build-up 150 (or 152) which comprises a higher number of wiring elements 108' (or 108") per area or volume. According to a preferred embodiment, the arrangement of the wiring elements 108, 108' in combination with lands (see Figure 12) may be adjusted so that the wiring planes 162 and 164 can be properly electrically interconnected.

**Figure 12** illustrates a plan view of wiring elements 108 of a detail of a wiring plane 162 of a component carrier 100 according to an exemplary embodiment of the invention. **Figure 13** illustrates a plan view of a larger portion of the wiring plane 162 of Figure 12.

Figure 12 shows a plan view of wiring elements 108 arranged side by side. In addition to the respective wiring element 108, a corresponding land 186 is shown as well. A land 186 may be a circular or annular structure extending laterally beyond an assigned wiring element 108. Adjacent wiring elements 108 with lands 186 are spaced by a distance, d. A diameter of a wiring element 108 is denoted as D1. A diameter of a land 186 is denoted as D2. D1, D2 and d can be used as design parameters or fitting parameters for optimizing the electric performance of a wiring plane 162.

When designing component carrier 100, this may comprise determining a spatial distribution of wiring elements 108 and lands 186, land diameter D2, drill diameter D1 and a functional grouping of the wiring elements 108 complying with a predefined specification (such as a design file). In other words, the specification may define target properties of the component carrier 100 to be designed and to be subsequently manufactured. Said distribution of wiring elements 108 including lands 186, the parameters d, D1 and D2, as well as the grouping of the wiring elements 108 to provide a certain (in particular electric) function in the framework of the component carrier 100 may then be adjusted accordingly. Spacing, d, between adjacent lands 186 of adjacent wiring elements 108 may be a further design parameter to be adjusted in this context. Also a minimum distance for a hexagonal virtual cell 126, Md, and/or a pitch, P, may be introduced in the determination process. The pitch, P, may define the center-to-center distance between adjacent wiring elements 108. Thus, the mentioned considerations may be taken into account when defining a core drilling set up. By correspondingly executing core drilling, a target ampacity of the component carrier 100 may be achieved.

Referring to Figure 12, the following formulas apply:

$$Md = \tfrac{1}{2}\,D2 + d + D2 + d + \tfrac{1}{2}\,D2$$

$$P = \tfrac{1}{2}\,D2 + d + \tfrac{1}{2}\,D2$$

The resulting minimum geometries are something that can be addressed modifying some of the same rules, which are driving the pitch, like for example the possibility of differentiating the diameter of the mechanically drilled through hole. The resulting pitch can then be modified to further enable other significant changes, such as enlarging some holes in respect of others. This may then establish a differential contribution to the overall characteristics of the substrate.

A further issue may be related to the demonstrated reliability of laser vias based of their placement in contact with the mechanically drilled through holes. The positioning of the laser vias may have a more robust behavior to thermal-mechanical fatigue, if the laser vias, are made landing on the annular ring of the metal cap, which is belonging to the cap of the mechanically drilled through holes. Reliability may be higher when these are contacting the metal cap in the center, or in correspondence to the edge of the mechanical drill.

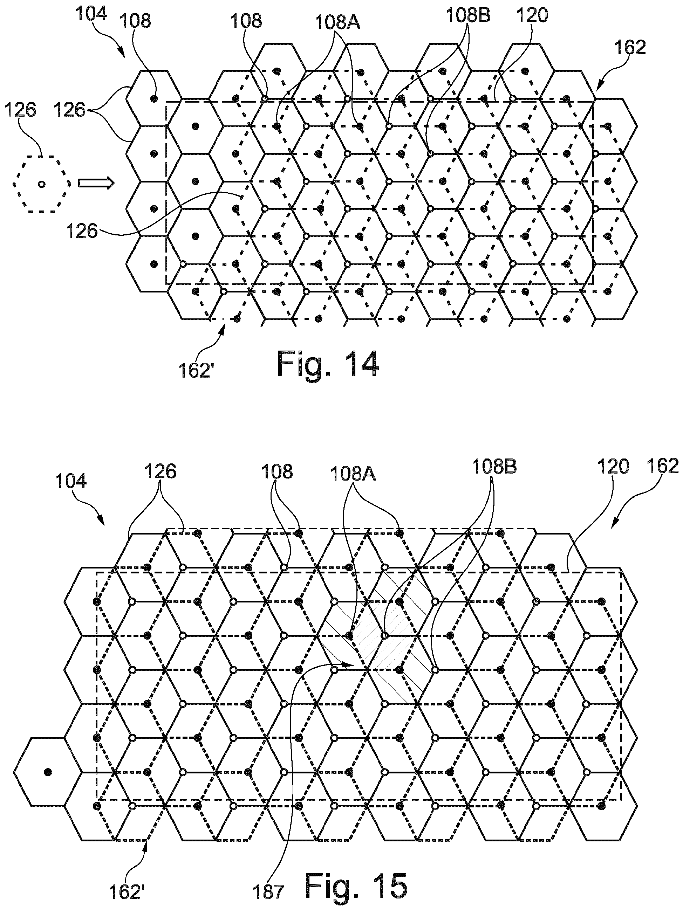

**Figure 14** illustrates a plan view of different wiring planes 162, 162' of a component carrier 100 according to an exemplary embodiment of the invention.

Figure 14 illustrates different kinds of wiring elements 108 in different wiring planes 162, 162', i.e. wiring elements of first type 108A in wiring plane 162 and wiring elements of second type 108B in wiring plane 162'. In the shown example, the wiring elements of first type 108A may be configured to provide a power voltage, whereas the wiring elements of second type 108B may be configured to provide a ground potential. A tessellation overlay of the patterns of the wiring elements of first type 108A and the wiring elements of second type 108B is illustrated in Figure 14. Figure 14 shows an arrangement corresponding to shadow area 120 of a surface mounted component 118. Here, two sets of mutually displaced Voronoi cells are overlaid, which may be distributed, providing the above-mentioned different electric functions, i.e power supply and provision of the ground potential. The wiring elements of first type 108A and the wiring elements of second type 108B may also relate to different vertical levels, for instance to two different vertical levels of wiring planes 162, 162'.

Every seed of the power feeding honeycomb structure may sit on one vertex of the structure. The disposition of these tessellations allows to create different level of service to the overall structure of the power feeding network. Only the necessary quantity of vertex may be occupied based on the computed power demand. The seed location represents the centroid of the mechanically drilled through hole, different seeds belonging to different tessellation may belong to different power domains. The overlapping geometrical mapping may allow to identify the areas of influence that every mechanically drilled through holes has. Furthermore, the intrinsically redundant structure is becoming more evident where it would be possible to identify that every power feeding structure is supported in this example by three return current mechanically drilled through holes, as also shown in Figure 15.

**Figure 15** illustrates a plan view of different wiring planes 162, 162' of a component carrier 100 according to an exemplary embodiment of the invention. The illustration of Figure 15 is similar to the one of Figure 14. In particular, Figure 15 shows an area of influence 187 illustrating a coverage in the die shadow area 120. Every point in the space is served by the wiring elements of second type 108B corresponding to the power domains. More specifically, every power providing wiring element of second type 108B is served by three redundant wiring elements of first type 108A providing an electric reference or ground potential (with possible smaller drill diameters).

More generally, a determination method according to an exemplary embodiment of the invention may link one wiring element of one wiring plane to a plurality of wiring elements of the adjacent next wiring plane.

Figure 15 highlights a portion of the wiring planes 162, 162' which is denoted by reference sign 187. Such a sub-portion may be subject to optimization, fitting or adaptation.

In a dual matrix, it may not be necessary to fill all vertexes. Some may remain available to be used if requirements will impose that. On the other hand, a strategic tessellation can be also used to partition the distribution according to the mapping of the power domains. An empty vertex may provide locations for further power domains.

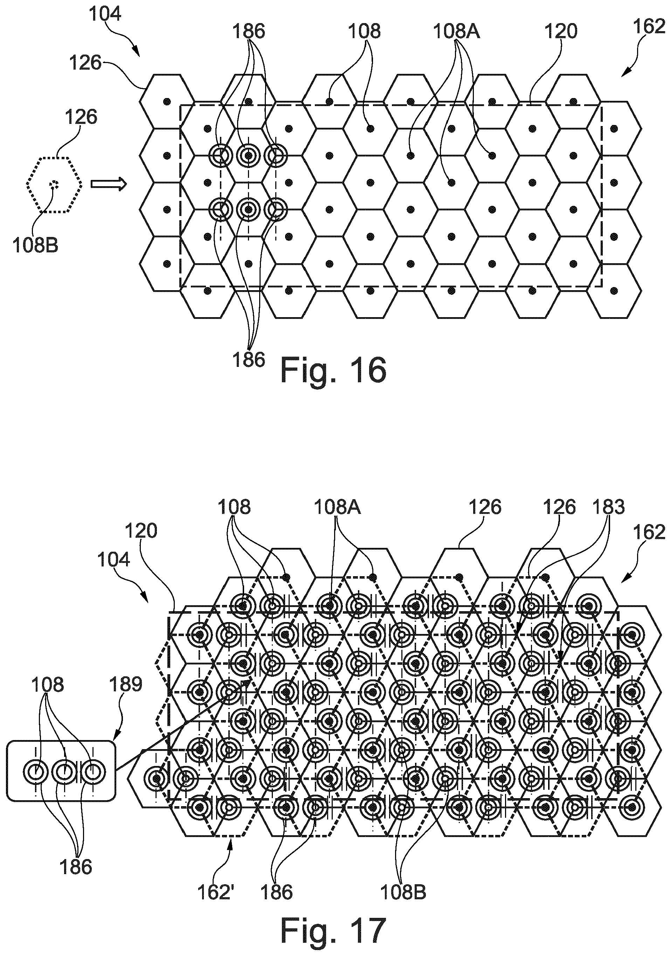

**Figure 16** illustrates a plan view of a wiring plane 162 of a component carrier 100 according to an exemplary embodiment of the invention, to which an additional wiring element of second type 108B is added. Again, tessellation of a die shadow area 120 is illustrated in Figure 16. In particular, Figure 16 shows how to create areas of influence for each power domain. As shown, an additional wiring element of second type 108B is added to the power distribution for wiring elements of first type 108A. Hence, it may be possible to integrate further structures in available vertexes.

Figure 16 illustrates again that also the lands 186 connected to the respective wiring elements 108 may be taken into account for the design of the component carrier 100.

**Figure 17** illustrates a plan view of different wiring planes 162, 162' of a component carrier 100 according to an exemplary embodiment of the invention.

As indicated by reference signs 108A, 108B, also the embodiment of Figure 17 shows wiring elements 108 provided for supplying a power voltage and other wiring elements 108 configured for providing a reference potential, such as the ground potential. The distribution scheme of Figure 17 thus allows to provide power and ground potential. Figure 17 demonstrates again the flexibility of the hexagon tessellation.

As indicated by reference sign 183, a respective empty vertex can be used for other power domains or to increase the level of redundancy of providing a reference potential (such as ground potential). This may allow to use smaller mechanically drilled through holes or localized addition of main power mechanically drilled through holes. A maximum density of mechanically drilled through holes is indicated by reference sign 189.

Figure 17 shows the high amount of design parameters which can be used for a fit for optimizing the electric performance.

**Figure 18** illustrates a plan view of different wiring planes 162, 162', 162", 162''' of a component carrier 100 according to an exemplary embodiment of the invention. In this embodiment, wiring elements of third type 108C in wiring plane 162" and wiring elements of fourth type 108D in wiring plane 162''' are provided in addition to the above defined wiring elements of first type 108A and wiring elements of second type 108B. For example, the wiring elements of first type 108A, the wiring elements of third type 108C and the wiring elements of fourth type 108D are provided for power supply at three different power levels, whereas the wiring elements of second type 108B are configured for providing a reference potential (such as ground potential). Hence, the architecture of Figure 18 shows that the provision of wiring elements 108 is freely scalable. In particular, multiple power voltages network partitioning is possible. Furthermore, it is possible to add additional power domains by areas.

Partitioning of the required drilling is possible according to a functional area under examination. The tessellation translates into a lower level of required drilled holes in the layers composing the core, and in particular to the layer that collects the power mechanically drilled through holes, which becomes of a less impacting configuration for the landing of laser vias from the top layer of the same core (or first build-up layer).

**Figure 19** illustrates a plan view of different wiring planes 162, 162' of a component carrier 100 according to an exemplary embodiment of the invention. Figure 19 illustrates that a method of distributing wiring elements 108 may comprises arranging the wiring elements 108 in accordance with hexagonal Voronoi cells 126 around respective wiring elements 108 and by combining sets of wiring elements 108 of neighbouring hexagonal Voronoi cells 126 to four-sided blocks 124. The latter may be parallelogram-type blocks. The arrangement of Figure 19 is compliant with an ampacity target of 10 A/mm². Figure 19 shows a coverage in the die shadow area 120.

Every point in the space may be served by the power domains. Six hexagons (for example of 447 μm side length) are shown with their mechanically drilled through holes (for instance of 225 μm drill diameter), and are filled with electrically conductive material. Copper paste can carry about 10 A in areas of 1.192 mm² and a temperature difference of 10° C. Ampacity is shown through a different geometrical space tessellation per 1 mm² unit of surface.

**Figure 20** illustrates a plan view of different wiring planes 162, 162' of a component carrier 100 according to an exemplary embodiment of the invention. A target ampacity of 10 A/mm² can be met by a configuration of a substrate with the design of Figure 20.

**Figure 21** illustrates a plan view of a wiring plane 162 of a component carrier 100 according to an exemplary embodiment of the invention. Figure 21 shows that the different wiring elements 108 in centers, in corners or elsewhere in relation to the hexagonal virtual cells 126 may also have different sizes. A cross-sectional area of a wiring element 108 may have an impact on, for example, its current carrying capability.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

**Claims**

1. A component carrier (100), which comprises:

   a stack (102) comprising at least one electrically conductive layer structure (104) and at least one electrically insulating layer structure (106);
   wherein the at least one electrically conductive layer structure (104) comprises a plurality of wiring elements (108) arranged in a wiring plane (162) in the at least one electrically insulating layer structure (106) to form:

   a first row (110) of equidistant wiring elements (108) arranged along a straight direction within the wiring plane (162); and
   a second row (112) of equidistant wiring elements (108) arranged along the straight direction within the wiring plane (162) and being offset along the straight direction with respect to the wiring elements (108) of the first row (110).

2. The component carrier (100) according to claim 1, wherein at least part of the wiring elements (108) are arranged at centers of hexagonal virtual cells (126) of the wiring plane (162), each of said hexagonal virtual cells (126) being adjacent one to the other sharing a respective side of a respective hexagon with a respective adjacent hexagon.

3. The component carrier (100) according to claim 2, wherein the hexagonal virtual cells (126) are delimited by a regular hexagon.

4. The component carrier (100) according to claim 2 or 3, wherein another part of the wiring elements (108) are arranged at corners (170) of the hexagonal virtual cells (126).

5. The component carrier (100) according to any of claims 1 to 4, wherein a mutual distance (b) between adjacent equidistant wiring elements (108) of the first row (110) equals to a mutual distance (b) between adjacent equidistant wiring elements (108) of the second row (112).

6. The component carrier (100) according to any of claims 1 to 5, comprising one of the following features:

   wherein an offset value (f) of the offset of the equidistant wiring elements (108) of the second row (112) with respect to the equidistant wiring elements (108) of the first row (110) along the straight direction is 1/2 of a mutual spacing (b) between adjacent equidistant wiring elements (108) of the first row (110);
   wherein an offset value (f) of the offset of the equidistant wiring elements (108) of the second row (112) with respect to the equidistant wiring elements (108) of the first row (110) along the straight direction is 1/3 of a mutual spacing (b) between adjacent equidistant wiring elements (108) of the first row (110).

7. The component carrier (100) according to any of claims 1 to 6, wherein the second row (112) is spaced with respect to the first row (110) along a further straight direction perpendicular to the straight direction.

8. The component carrier (100) according to any of claims 1 to 7, wherein a further electrically conductive layer structure (104') of the stack (102) comprises a plurality of further wiring elements (108') which are arranged in a further wiring plane (164) parallel to the wiring plane (162) and which have a corresponding pattern as but another density of wiring elements than the electrically conductive layer structure (104) with the first row (110) and the second row (112) of wiring elements (108).

9. The component carrier (100) according to any of claims 1 to 8, wherein the wiring elements (108) are arranged to form:

   a third row (114) next to the second row (112) and having an arrangement of wiring elements (108) as the first row (110); and
   a fourth row (116) next to the third row (114) and having an arrangement of wiring elements (108) as the second row (112).

10. The component carrier (100) according to any of claims 1 to 9, wherein the wiring elements (108) are grouped into a plurality of wiring element groups of different electric functions, wherein in particular different groups of wiring elements (108) are assigned to different electric voltage levels.

11. The component carrier (100) according to any of claims 1 to 10, comprising a component (118) being surface mounted on the stack (102), wherein the wiring elements (108) are arranged in a shadow area (120) of the surface mounted component (118).

12. The component carrier (100) according to any of claims 1 to 11, comprising at least one of the following features:

   wherein at least some of the wiring elements (108) function for distributing electric power in the component carrier (100);
   wherein some of the wiring elements (108) function for distributing signals in the component carrier (100);
   wherein some of the wiring elements (108) function for providing a reference potential, in particular a ground potential, in the component carrier.

13. A method of designing a component carrier (100) which comprises a stack (102) comprising at least one electrically conductive layer structure (104) and at least one electrically insulating layer structure (106), wherein the method comprises designing the at least one electrically conductive layer structure (104) to comprise a plurality of wiring elements (108) arranged in a wiring plane (162) in the at least one electrically insulating layer structure (106) to form:

   a first row (110) of equidistant wiring elements (108) arranged along a straight direction within the wiring plane (162); and
   a second row (112) of equidistant wiring elements (108) arranged along the straight direction within the wiring plane (162) and being offset along the straight direction with respect to the wiring elements (108) of the first row (110).

14. The method according to claim 13, wherein the method comprises arranging the wiring elements (108) for adjusting a number of wiring elements (108) in the wiring plane (162) complying with a predefined specification.

15. The method according to any of claims 13 to 14, wherein the method comprises arranging the wiring elements (108) in accordance with hexagonal Voronoi cells (126) around respective wiring elements (108) and by combining sets of wiring elements (108) of neighbouring hexagonal Voronoi cells (126) to four-sided blocks (124), in particular to parallelogram-type blocks.

Fig. 1

Fig. 2

Fig. 3

Fig. 4

Fig. 5

Fig. 6

Fig. 7

104    108    120    162

Fig. 8

100

108'    106
154    118    104'
164

150

102    162
104    122

152

158  160  108

104    108    120    162

126

126

Fig. 9

Fig. 10

Fig. 11

Fig. 12

Fig. 13

Fig. 14

Fig. 15

Fig. 16

Fig. 17

Fig. 18

Fig. 19

Fig. 21

Fig. 20